# EUROPEAN PATENT APPLICATION

(11) **EP 0 789 250 A2**
(43) Date of publication of application: **13.08.1997**
(21) Application number: 97101731.4
(22) Date of filing: 04.02.1997
(51) Int. Cl.: G01R 33/09, G11B 5/39

(54) **Thin film giant magnetoresistive cip transducer with flux guide yoke structure**

(30) Priority: 12.02.1996 US 600238
(71) Applicant: READ-RITE CORPORATION, Milpitas California 95035 (US)
(72) Inventor: Lederman, Marcos M., San Francisco, California 94107 (US); Kroes, Derek Jan, Fremont, California 94539 (US)
(74) Representative: Körber, Wolfhart, Dr. rer.nat.

(57) **Abstract**

A giant magnetoresistive (GMR) transducer employs a pair of flux guide yoke members (14, 15) that define a magnetic transducing gap (G). A GMR structure (11) formed of stack of multiple layers (11b, 11c, 11d) is located away from the transducing gap (G) between spaced portions of one of the flux guide yoke members (14, 15) and is electrically connected to the facing surfaces of these spaced portions. When a sense current is supplied through the spaced portions of the one flux guide member (14, 15) and through the GMR structure (11), a current-in-the-plane (CIP) mode of operation of the transducer is effectuated. Magnetic bias (21) is supplied to the GMR structure either by a permanent magnet or by a current-carrying bias conductor.

## Description

### CROSS-REFERENCE TO RELATED APPLICATION

Copending application Serial No. 08/600,239 (Attorney Docket A23495), filed February 12, 1996 and assigned to the same assignee as the present application, discloses a thin film transducer that employs a giant magnetoresistance (GMR) with a magnetic flux guide yoke structure and operates in a current-perpendicular-to-the-plane (CPP) mode.

### BACKGROUND OF THE INVENTION

### Field of the Invention

This invention relates to a thin film magnetic transducer incorporating magnetic yoke members which act as guides for magnetic flux and a giant magnetoresistive sensor for reading magnetically recorded information.

### Description of the Prior Art

The use of magnetic transducers employing sensors using giant magnetoresistance (GMR) has been known for some time. U.S. Patent 4,949,039 to Grunberg discloses a thin film transducer employing a stack of spaced ferromagnetic layers separated from each other by layers of nonmagnetic metal such as copper, silver or gold, or antiferromagnetic material. Thus, alternate ferromagnetic layers are magnetized in opposite directions. The nonmagnetic/ antiferromagnetic layers are composed of materials which cause a spin-dependent electron scattering at the layer interfaces. The magnetic resistance change, termed giant magnetoresistance, in such an assembly in response to magnetic flux sensed by the transducer is substantially greater than that observed in structures which do not employ antiparallel magnetization layers and such intermediate nonmagnetic/antiferromagnetic layers.

U.S. Patent 5,270, 895 to Ruigrok et al describes a thin film magnetic transducer employing a yoke type flux guide which is shared between the read portion and the write portion of the transducer to improve the operation of the read and write functions. In the structures shown in that reference, the magnetoresistive (MR) element is positioned outside of the yoke members.

A publication entitled Giant Magnetoresistance of (001) Fe/(001) Cr Magnetic Superlattices, Baibich et al, Physical Review Letters, Volume 61, Number 21, page 2472, 1988, discusses the effects on the magnetoresistance of Fe/Cr magnetic lattices of variations in the Cr layer thickness. The giant magnetoresistance is ascribed to spin-dependent scattering at the interface between Fe and Cr layers.

A publication entitled Performance of Yoke Type GMR Heads, Folkerts et al, IEEE Transactions on Magnetics, November 1995 discloses a spin valve transducer in which the sensing element is positioned above the two separated components of a yoke type flux guide.

### SUMMARY OF THE INVENTION

In accordance with this invention, a thin film multilayer GMR transducer assembly comprises upper and lower flux guide yoke members that couple magnetic flux to the GMR structure. One of the flux guide yoke members has a gap which contains the GMR structure. The GMR structure is spaced from the air bearing surface (ABS) of the air bearing slider (not shown) which supports the transducer so that increased space is made available to allow the number of layers in the GMR stack structure and the length and width of the stack to be optimized. With this configuration, the complexity of the manufacturing processes is significantly reduced.

In one embodiment of the invention, conductor leads supply sense current to the multilayer GMR structure through a flux guide yoke member to produce a current-in-the plane (CIP) mode. Magnetic bias is provided to the multilayer GMR structure by means of a permanent magnet located adjacent to each end of the GMR structure. In an alternate embodiment, magnetic bias is provided by current-carrying conductors located adjacent to the GMR structure. In a further embodiment, a bias magnetic field is produced by a permanent magnet structure located above the GMR structure.

### DESCRIPTION OF THE DRAWINGS

Fig 1A is an isometric view of one embodiment of the present invention;
Fig. 1B is a schematic plan representation of the magnetic and electrical elements of the embodiment of Fig 1;
Fig. 2A is an isometric view of an alternate embodiment of the invention in which the magnetic bias is provided by electrical conductors carrying a bias current;
Fig. 2B is a schematic plan representation of the magnetic and electrical elements of the embodiment of Fig 2;
Fig. 3A is an isometric view of an additional alternative embodiment of the invention utilizing a permanent magnet; and
Fig. 3B is a schematic plan representation of the magnetic and electrical elements of the embodiment of Fig 3.

### DESCRIPTION OF THE PREFERRED EMBODIMENT

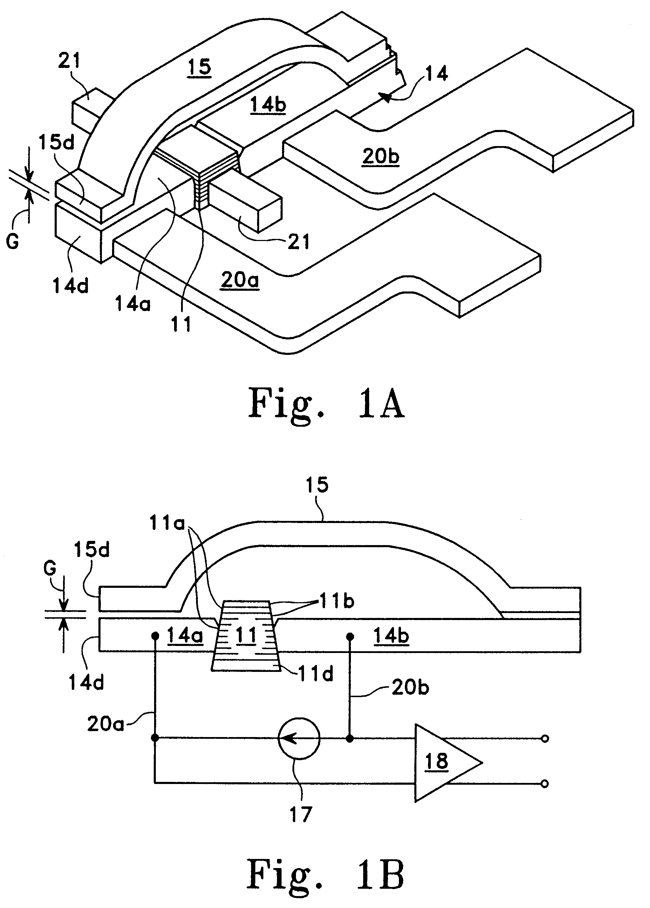

With reference to Fig. 1A a thin film magnetic transducer comprises a magnetic yoke formed with a lower flux guide yoke member 14 and an upper flux guide or yoke member 15, each having pole tip regions defining a transducing gap G. A multilayer GMR structure 11 is positioned between and in magnetic and electrical contact with two separate portions 14a, 14b of the lower flux guide yoke member 14. As is known in the art and as shown in Fig. 1B, the multilayer GMR structure 11 includes a stack of alternating ferromagnetic layers 11b and nonmagnetic metallic/antiferromagnetic layers 11c. GMR structure 11 may also include a lower seed layer or buffer layer 11d of material such as Fe or Ru or other suitable material to maximize the magnetoresistance of the GMR stack.

With reference to Fig.1A, sense current is supplied to GMR structure 11 through a pair of conductive lead members 20a, 20b. Current flows from conductive lead 20a through yoke portion 14a to structure 11 and then through yoke portion 14b to conductive lead 20b, resulting in a CIP mode of operation of the device. As shown in Fig. 1B, the sense current may be supplied from a current source 17. Variations in the voltage drop across GMR structure 11 are detected in amplifier 18 and supplied to suitable utilization means (not shown) as an indication of the magnetic flux sensed by the transducer.

Magnetic bias is provided to multilayer GMR structure 11 by permanent magnet means 21 which exerts a magnetic field perpendicular to the induced field to reduce Barkhausen noise and to optimize the sensitivity (operating point) of the GMR structure. The upper flux guide yoke member 15 extends over GMR structure 11 to provide magnetic coupling of the induced field with GMR structure 11. The faces 14d, 15d of the lower and upper yoke members 14 and 15 respectively are closely spaced from each other by a distance G representing the read gap. In operation, read gap G is positioned closely adjacent to or in intermittent contact with a recording medium, such as a magnetic disk (not shown), for transducing information that is sensed by the transducer.

The structure of Fig. 1A provides a GMR transducer assembly in which the GMR structure 11 is spaced from the ABS by the ends of yoke members 14, 15, and the number and size of the GMR stack layers, including their length and width, can be optimized. As an alternative to the structure of Fig. 1A, GMR structure 11 may be positioned between portions of upper yoke member 15 rather than between portions of yoke 14 as shown in Fig. 1A.

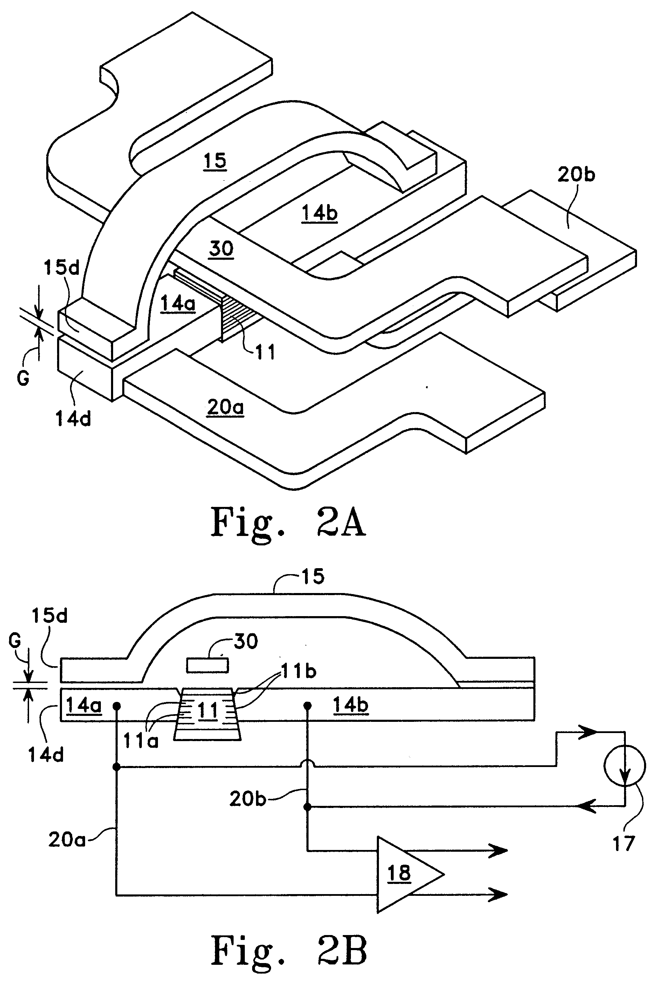

Figs. 2A and 2B illustrate an alternative embodiment of the invention in which the magnetic bias for the GMR structure is provided by electrical conductor means. In Fig. 2A, reference numeral 30 identifies an electrical conductor which carries a bias current to produce a biasing magnetic field on GMR stack 11 in a direction parallel to the magnetic field produced by the field through yoke member 14, 15. Fig. 2B shows current source 17 providing a sense current through conductors 20a, 20b and flux guide yoke portions 14a, 14b, with bias conductor 30 positioned above and in magnetic proximity to GMR structure 11.

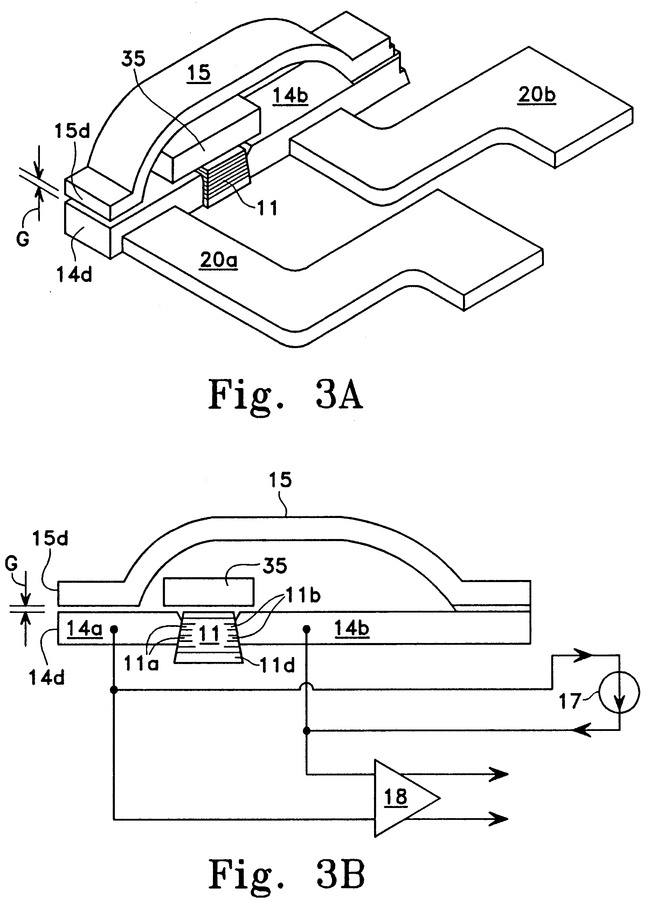

Figs. 3A and 3B illustrate another alternative embodiment of the invention utilizing permanent magnet bias means in the form of a permanent magnet 35. Magnet 35 generates a biasing magnetic field as is well known in the art.

## Claims

1. A multilayer giant magnetoresistive thin film transducer for coaction with a magnetic recording medium comprising:
a magnetic yoke including a first flux guide member (14) and a second flux guide member (15) spaced from said first flux guide member (14), said first and said second flux guide members (14, 15) having ends that are spaced from each other to form a transducing gap (G) adapted to be located adjacent to the magnetic recording medium, one of said flux guide members (14, 15) having two separate portions (14a, 14b);
a multilayer giant magnetoresistive structure (11) disposed in said one of said flux guide members (14, 15) between said two separate portions (14a, 14b) and spaced from said transducing gap (G) such that said structure lies in the path of magnetic flux induced in said magnetic yoke by said magnetic recording medium, said giant magnetoresistive structure (11) being electrically connected to said two separate portions (14a, 14b) of said one flux guide member such that each of said separate portions (14a, 14b) acts as an electrical lead for said multilayer giant magnetoresistive structure (11), whereby electrical current passing through said multilayer giant magnetoresistive structure (11) and said separate portions (14a, 14b) of said flux guide member flows in the planes of the multiple layers of said multilayer giant magnetoresistive structure (11);
said multilayer giant magnetoresistive structure (11) comprising a plurality of pairs of layers (11b) of ferromagnetic material and layers (11c) of a metal selected from the group of copper, silver and gold;
each of said layers (11b) of ferromagnetic material being adjacent to one of said layers (11c) of said selected metal; and
magnetic biasing means (21) positioned in magnetic proximity to said multilayer giant magnetoresistive structure (11) for providing a magnetic bias to said giant magnetoresistive structure (11).

2. A transducer as in claim 1 wherein said magnetic biasing means (21) comprises permanent magnet means located at both sides of said magnetoresistive structure (11).

3. A transducer as in claim 1 wherein said magnetic biasing means (21) comprises an electrical conductor located in magnetic proximity to said magnetoresistive multilayer and between said first and said second flux guide members (14, 15) for carrying bias current.

4. A transducer as in claim 1 wherein said magnetic biasing means (21) comprises permanent magnet means positioned above said magnetoresistive structure (11), so that the magnetization direction of said permanent magnet means is in a direction in a plane parallel to said layers of said multilayer magnetoresistive structure (11) and in a direction either parallel to or perpendicular to said first and second flux guide members (14, 15).

5. A transducer as in any one of claims 1 to 4 including a layer (11d) of buffer material, said magnetoresistive structure (11) being positioned over said buffer material layer (11d) whereby the magnetoresistance of said magnetoresistive structure (11) is effectively increased.

6. A transducer as in claim 5 wherein said magnetic biasing means (21) comprises permanent magnets located at both sides of said multilayer magnetoresistive structure (11).

7. A transducer as in claim 5 wherein said magnetic biasing means (21) comprises an electrical conductor located in magnetic proximity to said multilayer magnetoresistive structure (11) and between said first and said second flux guide members (14, 15) for carrying bias current.

8. A transducer as in claim 5 wherein said magnetic biasing means (21) comprises permanent magnet means positioned above said multilayer magnetoresistive structure (11), so that the magnetization direction of said permanent magnet means is in a direction in a plane parallel to said layers of said magnetoresistive structure and in a direction either parallel to or perpendicular to said first and said second flux guide members (14, 15).
